(19) Europäisches Patentamt
European Patent Office
Office européen des brevets

(11) **EP 4 474 106 A1**

(12) **EUROPEAN PATENT APPLICATION**
published in accordance with Art. 153(4) EPC

(43) Date of publication:
**11.12.2024 Bulletin 2024/50**

(21) Application number: **23749750.8**

(22) Date of filing: **31.01.2023**

(51) International Patent Classification (IPC):
**B24B 37/24** (2012.01)     **C08G 18/00** (2006.01)
**H01L 21/304** (2006.01)

(52) Cooperative Patent Classification (CPC):
**B24B 37/24; C08G 18/00; H01L 21/304**

(86) International application number:
**PCT/JP2023/003092**

(87) International publication number:
**WO 2023/149434 (10.08.2023 Gazette 2023/32)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **02.02.2022 JP 2022015063**

(71) Applicant: **Kuraray Co., Ltd.
Kurashiki-shi, Okayama 710-0801 (JP)**

(72) Inventors:
• **SUNAYAMA, Azusa
Kurashiki-shi, Okayama 713-8550 (JP)**
• **GOSHI, Yuko
Tokyo 100-0004 (JP)**
• **KATO, Mitsuru
Kurashiki-shi, Okayama 713-8550 (JP)**

(74) Representative: **Vossius & Partner
Patentanwälte Rechtsanwälte mbB
Siebertstrasse 3
81675 München (DE)**

(54) **POLISHING LAYER, POLISHING PAD, METHOD FOR MANUFACTURING POLISHING PAD, AND POLISHING METHOD**

(57)     The present invention relates to a polishing layer containing a polyurethane, in which an elongation at break of the polyurethane at a tensile speed of 50 mm/min after saturated and swollen by water of 50 °C is less than 100 %, a polishing pad equipped with the polishing layer and a method for producing thereof, and a polishing method which uses the polishing pad.

[Fig. 1]

**Description**

Technical Field

The present invention relates to a polishing layer, a polishing pad, a method for producing a polishing pad, and a polishing method.

Background Art

As a polishing method for planarizing the surface of semiconductor wafer, CMP (Chemical Mechanical Polishing (Planarization)) is used. CMP is a method for polishing the object to be polished with high accuracy using a polishing pad while supplying slurry containing abrasive grains and reaction solution to the surface of the object to be polished.

As the material constituting a polishing layer of the polishing pad used in CMP, polyurethane is used. Polyurethane has the advantage of having excellent affinity with slurry and easily achieving a high polishing rate since it has good processability and durability, and is hydrophilic.

Incidentally, high integration and multilayer wiring of semiconductor wafer are becoming more and more progressed, and along with this, higher polishing accuracy has become required than before even in CMP of semiconductor wafer. In order to meet such demands, studies to improve the performance of polishing pads are being conducted.

For example, in Patent Literature 1, as a polishing pad which can improve polishing performances, a polishing pad made of hydrophilic materials which satisfy the specific properties, is disclosed.

In Patent Literature 2, as a solution for obtaining a high polishing rate by improving the dressing properties in a polishing pad, a polishing pad containing a polyurethane foamed sheet as a polishing layer, in which the sheet has an elongation of 100% to 600%, a breaking strength of 0.1 kgf/mm$^2$ to 2.0 kgf/mm$^2$, and a value of elongation/breaking strength of 300 to 1100, is disclosed.

Citation List

Patent Literature

> PTLI: WO99/07515A
> PTL2: JP2016-68250A

Summary of Invention

Technical Problem

In order to increase the polishing rate and polishing accuracy in CMP, particularly the uniformity of the polishing rate within the surface to be polished (hereinafter also referred to as "polishing uniformity"), it is effective to increase the hardness of the polishing layer. From this viewpoint, Patent Literature 2 also discloses a polishing pad which limits a shore A hardness in a specific range.

However, according to studies conducted by the present inventors, it is found that when the hardness of polishing layer is increased, the defect is easier to occur on the surface to be polished of the object to be polished. Therefore, it has been difficult to achieve both improvement in polishing uniformity and low defect properties which keep the number of defects low.

The present invention has been made in view of the above-mentioned conventional problems, and it is to provide a polishing layer which can achieve both polishing uniformity and low defect properties with high degree in CMP, a polishing pad equipped with the polishing layer and a method for producing thereof, and a polishing method using the polishing pad.

Solution to Problem

The present inventors have presumed that the cause for occurring of defects when using the conventional polishing pads is that large polishing debris generated from the polishing layer forms aggregates with abrasive grains, and the aggregates come into contact with the surface to be polished and pressurized. Further, they found that a polishing layer containing a polyurethane having a specific elongation at break can solve the above problems, and completed the present invention.

The present invention relates the below items [1] to [13].

[1] A polishing layer containing a polyurethane, in which an elongation at break of the polyurethane at the tensile speed of 50 mm/min after saturated and swollen by water of 50 °C is less than 100 %.

[2] The polishing layer according to the above item [1], in which a yield stress of the polyurethane at the tensile speed of 50 mm/min after saturated and swollen by water of 50 °C is 43 MPa or more.

[3] The polishing layer according to the above item [1] or [2], in which a D hardness of the polyurethane after saturated and swollen by water of 50 °C is 65 or more.

[4] The polishing layer according to any one of the above items [1] to [3],

in which a contact angle with water of the polyurethane is less than 75 degrees.

[5] The polishing layer according to any one of the above items [1] to [4],

in which the polyurethane contains structural units derived from polymer polyol,

in which the polymer polyol contains 15 mol% or more of polyethylene glycol.

[6] The polishing layer according to any one of the above items [1] to [5],

in which the polyurethane is thermoplastic.

[7] The polishing layer according to any one of the above items [1] to [6], having a density of 0.7 g/cm$^3$ or more.

[8] The polishing layer according to any one the of items [1] to [7] which is a molded article of the polyurethane.

[9] The polishing layer according to the above items [8],

in which the molded article is a non-foamed molded article.

[10] The polishing layer according to any one of the above items [1] to [9],

in which the polishing layer contains recesses on the polishing surface.

[11] A polishing pad equipped with the polishing layer according to any one of the above items [1] to [10].

[12] A method for producing a polishing pad, which is a method for producing the polishing pad according to the above item [11], containing one or more steps selected from the group consisting of a step of forming the polishing layer and a step of processing the polishing layer.

[13] A polishing method which uses the polishing pad according to the above item [11].

Advantageous Effects of Invention

According to the present invention, in CMP, it is possible to provide a polishing layer which achieve both polishing uniformity and low defect properties with high degree, a polishing pad equipped with the polishing layer and a method for producing thereof, and a polishing method using the polishing pad.

Brief Description of Drawings

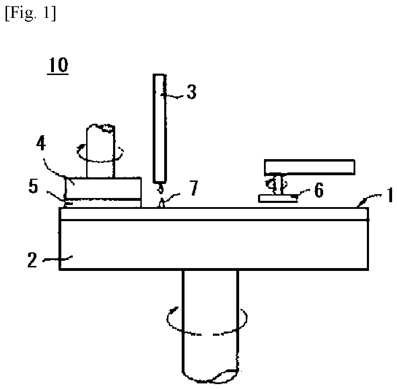

Fig. 1 is a schematic diagram illustrating a polishing method using a polishing pad of the present invention.

Description of Embodiments

It will be explained in the following based on an example of the embodiments of the present invention. However, the embodiments shown below is an example for embodying the technical idea of the present invention, and the present invention is not limited to the following description.

The present invention also includes the embodiments in which the items described in this description are arbitrary selected or arbitrary combined.

In this description, preferred regulations may be arbitrary selected, and it can be said that the combination of the preferred regulations is more preferable.

In this description, the expression of "XX to YY" means "XX or more and YY or less".

In this description, the lower limit values and the upper limit values described in stages for the preferred numerical ranges (for example, the range of the content) can be independently combined. For example, the expression of "preferably 10 to 90, more preferably 30 to 60" can mean "10 to 60" by combining "the preferable lower limit value (10)" and "the more preferable upper limit value (60)".

[Polishing layer]

A polishing layer of the present invention is a polishing layer containing a polyurethane, in which an elongation at break of the polyurethane after saturated and swollen by water of 50 °C and at the tensile speed of 50 mm/min is less than 100 %.

Hereinafter, a polyurethane, in which an elongation at break of the polyurethane at the tensile speed of 50 mm/min after saturated and swollen by water of 50 °C is less than 100 %, contained in the polishing layer of the present invention is referred to as "polyurethane (PU)".

<Polyurethane (PU)>

Hereinafter, polyurethane (PU) will be explained in detail.

Note that the components constituting polyurethane (PU) do not contain abrasive grains. That is, elongation at break, yield stress, D hardness, and contact angle with water of polyurethane (PU) described below mean the values measured by using polyurethane (PU) which does not contain abrasive grains as a measurement object. Although this does not exclude embodiments contain abrasive grains from the polishing layer of the present invention, the polishing layer of the present invention preferably does not contain the abrasive grains.

(Elongation at break)

The elongation at break at the tensile speed of 50 mm/min after saturated and swollen by water of 50 °C of polyurethane (PU) (hereinafter, it is also simply referred to as "elongation at break after water swelling") is less than 100 %.

The polishing layer of the present invention can achieve both polishing uniformity and low defect properties with high degree in CMP, by containing polyurethane (PU) in which the elongation at break after water swelling is less than 100 %. This is presumed that large polishing debris which is presumed to be the cause of occurring of defect, is difficult to be generated in CMP for the polishing layer of the present invention which contains polyurethane (PU), since the elongation at break after water swelling of polyurethane (PU) is less than 100 %.

The elongation at break after water swelling of polyurethane (PU) is less than 100 %, preferably 99 % or less, more preferably 95 % or less, even more preferably 90 % or less.

When the elongation at break after water swelling of polyurethane (PU) is withing the above range, both of polishing uniformity and low defect properties can be highly achieved.

The lower limit value of the elongation at break after water swelling of polyurethane (PU) is not particularly limited, however it may be 20 % or more, 30 % or more, or 40 % or more, from the viewpoint of ease of manufacturing and the like.

Note that the elongation at break after water swelling can be measured by the method described in Examples.

The elongation at break of polyurethane can be adjusted within the above range by, for example, introducing a rigid skeleton having an aliphatic unsaturated bond or an aromatic ring as the molecular structure of polyurethane derived from a chain extender.

(Yield stress)

The yield stress at the tensile speed of 50 mm/min after saturated and swollen by water of 50 °C (hereinafter, also simply referred to as "yield stress after water swelling") of polyurethane (PU) is not particularly limited, however it is preferably 43 MPa or more, more preferably 44 MPa or more, even more preferably 45 MPa or more.

When the yield stress after water swelling of polyurethane (PU) is within the above range, it tends to be possible to further improve polishing uniformity.

The upper limit value of the yield stress after water swelling of polyurethane (PU) is not particularly limited, it may be 90 MPa or less, 80MPa or less, or 70MPa or less, from the viewpoint of ease of manufacturing and the like.

The yield stress after water swelling can be measured by the method described in Examples.

(D hardness)

The D hardness after saturated and swollen by water of 50 °C (hereinafter, also simply referred to as "D hardness after water swelling") of polyurethane (PU) is not particularly limited, however it is preferably 65 or more, more preferably 70 or more, even more preferably 75 or more.

When the D hardness after water swelling of polyurethane (PU) is within the above range, it tends to be possible to further improve polishing uniformity.

The upper limit value of the D hardness after water swelling of polyurethane (PU) is not particularly limited, it may be 95 or less, 90 or less, or 85 or less, from the viewpoint of ease of manufacturing and the like.

The D hardness after water swelling can be measured based on the methods described in Examples.

(Contact angle with water)

The contact angle with water of polyurethane (PU) is not particularly limited, however it is preferably less than 75 degrees, more preferably less than 73 degrees, even more preferably less than 70 degrees.

When the contact angle with water of polyurethane (PU) is within the above range, the hydrophilicity of the polishing surface is improved and the discharge properties and dispersibility of polishing debris are improved, and it tends to be possible to highly achieve both polishing uniformity and low defect properties.

The lower limit value of the contact angle with water of polyurethane (PU) is not particularly limited, however it may be 30 degrees or more, 40 degrees or more, or 50 degrees or more, from the viewpoint of ease of manufacturing and the like.

Note that in this description, the contact angle with water means the contact angle 2 seconds after dropping water, and specifically, it can be measured based in the methods described in Examples.

<Properties of polyurethane (PU)>

Polyurethane (PU) may be thermosetting or thermoplastic, however from the viewpoint of reducing contact pressure to the surface to be polished and further suppressing the occurrence of defects, it is preferably thermoplastic.

(Structure of polyurethane (PU))

Next, structures of polyurethane (PU) will be explained.

Polyurethane (PU) preferably contains structural units derived from polymer polyol from the viewpoint of ease of obtaining the polishing layer which maintains the required properties such as elongation at break, rigidity, hardness, and hydrophilic.

Polymer polyol may be used alone or may be used in combination of two or more thereof.

[Polymer polyol]

In this description, "polymer polyol" means polyol which has a molecular weight of over 300.

Note that, the "molecular weight" of the polymer polyol and the chain extender described below means the molecular weight calculated from the structural formula in the case of a compound having a single molecular weight, and means the number average molecular weight in the case of a polymer.

Examples of the polymer polyol include polyether diol, polycarbonate diol, polyester diol. Among these, from the viewpoint of ease of availability and reactivity, polyether diol and polyester diol are preferred, polyether diol is more preferred.

{Polyether diol}

Examples of the polyether diol include polyethylene glycol (PEG), polypropylene glycol, polytetramethylene glycol (PTMG), poly(methyltetramethylene glycol), glycerin-based polyalkylene ether glycol. Among these, polyethylene glycol and polytetramethylene glycol are preferred.

The content of polyether diol in polymer polyol is not particularly limited, however it is preferably 90 mol% or more, more preferably 95 mol% or more, even more preferably 99 mol% or more, even further preferably 100 mol%.

When the content of polyether diol is within the above range, the hydrophilicity of polyurethane (PU) tends to be good.

The content of polyethylene glycol in polymer polyol is not particularly limited, however it is preferably 15 mol% or more, more preferably 20 mol% or more, even more preferably 25 mol% or more, and it is preferably 90 mol% or less, more preferably 80 mol% or less, even more preferably 70 mol% or less.

When the content of polyethylene glycol is equal to or greater than the above lower limit value, the hydrophilicity of polyurethane (PU) is further improved, and the discharge properties and dispersibility of polishing debris are improved, therefore, it tends to be possible to highly achieve both polishing uniformity and low defect properties. Further, when the content of polyethylene glycol is equal to or less than the above upper limit value, excessive moisture absorption is suppressed, and the change in resin hardness when drying and water swelling becomes smaller, and the stability of polishing performance tends to be better.

The content of polyethylene glycol in polymer polyol can be calculated based on the methods described in Example.

{Polyester diol}

Examples of the polyester diol include polyester diols obtained by directly esterifying or transesterifying a dicarboxylic acid or an ester-forming derivative, such as its ester or anhydride, and a low-molecular diol.

Examples of the dicarboxylic acid include aliphatic dicarboxylic acids having 2 to 12 carbon atoms such as oxalic acid, succinic acid, glutaric acid, adipic acid, pimelic acid, suberic acid, azelaic acid, sebacic acid, dodecanedicarboxylic acid, 2-methylsuccinic acid, 2-methyladipic acid, 3-methyladipic acid, 3-methylpentanedioic acid, 2-methyloctanedioic acid, 3,8-dimethyldecanedioic acid, and 3,7-dimethyldecanedioic acid: aliphatic dicarboxylic acids such as dimerized aliphatic dicarboxylic acids(dimer acids) having 14 to 48 carbon atoms obtained by dimerizing unsaturated fatty acids obtained by fractional distillation of triglycerides, and hydrogenated products thereof (hydrogenated dimer acids): alicyclic dicarboxylic acids such as 1,4-cyclohexanedicarboxylic acid; and aromatic dicarboxylic acids such as terephthalic acid, isophthalic acid, and orthophthalic acid. Further, examples of the dimer acid and hydrogenated dimer acid include the product names "Pripol 1004", "Pripol 1006", "Pripol 1009", and "Pripol 1013", manufactured by Unikema. One kind of these may be used singly, or two or more kinds thereof may be used in combination.

Furthermore, examples of the low-molecular diol include aliphatic diols such as ethylene glycol, 1,3-propanediol, 1,2-propanediol, 2-methyl-1,3-propanediol, 1,4-butanediol, neopentyl glycol, 1,5-pentanediol, 3-methyl- 1,5-pentanediol, 1,6-hexanediol, 1,7-heptanediol, 1,8-octanediol, 2-methyl-1,8-octanediol, 1,9-nonanediol, and 1,10- decanediol; and alicyclic diols such as cyclohexanedimethanol and cyclohexanediol. One kind of these may be used singly, or two or more kinds thereof may be used in combination. Among these, diols having 6 to 12 carbon atoms are preferred, diols having 8 to 10 carbon atoms are more preferred, diols having 9 carbon atoms are even more preferred.

{Polycarbonate diol}

Examples of the polycarbonate diol include what is obtained by a reaction of low-molecular diols and carbonate compounds.
Examples of the low-molecular diol for producing polycarbonate diol include the above-described low-molecular diols.
Examples of the carbonate compounds for producing polycarbonate diol include dialkyl carbonate, alkylene carbonate, and diaryl carbonate.
Examples of dialkyl carbonate include dimethyl carbonate and diethyl carbonate.
Examples of alkylene carbonate include ethylene carbonate.
Examples of diaryl carbonate include diphenyl carbonate.

{Number average molecular weight of polymer polyol}

The number average molecular weight of the polymer polyol is more than 300, preferably 450 to 3,000, more preferably 500 to 2,700, even more preferably 550 to 2,400.
When the number average molecular weight of the polymer polyol is within the above-described range, the polishing layer which maintains the required properties such as rigidity, hardness, and hydrophilicity tends to be easily obtained.
Note that the number average molecular weight of polymer polyol means a number average molecular weight calculated based on the hydroxyl value measured in accordance with JIS K 1557-1:2007.
The polyurethane (PU) preferably further includes a structural unit derived from polyisocyanate and a structural unit derived from a chain extender.
Polyisocyanate and the chain extender may each be used alone or in combination of two or more.

{ Polyisocyanate}

As the polyisocyanate, polyisocyanate which is used for producing the usual polyurethane can be used, and the examples include aliphatic or alicyclic diisocyanates such as ethylene diisocyanate, tetramethylene diisocyanate, pentamethylene diisocyanate, hexamethylene diisocyanate, 2,2,4-trimethylhexamethylene diisocyanate, 2,4,4-trimethylhexamethylene diisocyanate, dodecamethylene diisocyanate, isophorone diisocyanate, isopropylidene bis(4-cyclohexyl isocyanate), cyclohexylmethane diisocyanate, methylcyclohexane diisocyanate, 4,4'-dicyclohexylmethane diisocyanate, lysine diisocyanate, 2,6-diisocyanatomethyl caproate, bis(2-isocyanatoethyl) fumarate, bis(2-isocyanatoethyl) carbonate, 2-isocyanatoethyl-2,6-diisocyanatohexanoate, cyclohexylene diisocyanate, methylcyclohexylene diisocyanate, and bis(2-isocyanatoethyl)-4-cyclohexene; and aromatic diisocyanates such as 2,4'-diphenylmethane diisocyanate, 4,4'-diphenylmethane diisocyanate (MDI), 2,4-tolylene diisocyanate, 2,6-tolylene diisocyanate, m-phenylene diisocyanate, p-phenylene diisocyanate, m-xylylene diisocyanate , p-xylylene diisocyanate, 1,5-naphthylene diisocyanate, 4,4'-diisocyanatobiphenyl, 3,3'-dimethyl-4,4'-diisocyanatobiphenyl, 3,3'-dimethyl-4 , 4'-diisocyanatodiphenylmethane, chlorophenylene-2,4-diisocyanate, and tetramethylxylylene diisocyanate. Among these, 4,4'-diphenylmethane diisocyanate (MDI) is preferable, from the viewpoint of improving the abrasion resistance of the polishing layer.

[Chain extender]

In this description, "chain extender" means a compound having a molecular weight of 300 or less, which is used for the purpose of increasing the molecular weight of polyurethane.

As the chain extender, chain extenders used in manufacturing the usual polyurethane can be used. Specifically, low molecular weight compounds having a molecular weight of 300 or less, which have two or more active hydrogen atoms in the molecule which can react with isocyanate groups, can be used, and the examples include diols having a molecular weight of 300 or less, and diamines having a molecular weight of 300 or less. Among these, diols having a molecular weight of 300 or less are preferred.

{Diols having a molecular weight of 300 or less}

The chain extender used in the production of polyurethane (PU) preferably contains diols having a molecular weight of 300 or less, and as the diols having a molecular weight of 300 or less, it is more preferable that diols having a molecular weight of 300 or less and having aliphatic unsaturated bond or an aromatic ring in the molecule (hereinafter, also simply referred to as "diol having an aliphatic unsaturated bond or aromatic ring"), are contained.

When the chain extender contains a diol having an aliphatic unsaturated bond or an aromatic ring, the elongation at break after water swelling of polyurethane (PU) can be adjusted to be low.

Examples of the diols having an aliphatic unsaturated bond or an aromatic ring include diols having an aliphatic unsaturated bond in the molecule such as cis-2-butene-1,4-diol (CBD), trans-2-butene-1,4-diol (TBD), and trans-2,3-dibromo-2-butene-1,4-diol; and diols having an aromatic ring in the molecule such as 1,4-benzenedimethanol (BDM), 1,4-bis($\beta$-hydroxyethoxy)benzene, bis($\beta$-hydroxyethyl)terephthalate, m-xylylene glycol, and p-xylylene glycol.

Among the diols having an aliphatic unsaturated bond or an aromatic ring, CBD, TBD, and BDM are preferred from the viewpoint of ease of adjusting physical properties such as elongation at break, CBD is more preferred from the viewpoint of ease of manufacturing.

When the chain extender contains a diol having an aliphatic unsaturated bond or an aromatic ring, the content of the diol having an aliphatic unsaturated bond or an aromatic ring in the chain extender is not particularly limited, however it is preferably 10 to 70% by mass, more preferably 20 to 60% by mass, even more preferably 25 to 50% by mass.

When the content of the diol having an aliphatic unsaturated bond or an aromatic ring is within the above range, the elongation at break after water swelling tends to be easily adjusted to be low.

Examples of diols having a molecular weight of 300 or less include, in addition to those listed above, diols such as ethylene glycol, diethylene glycol (DEG), 1,2-propanediol, 1,3-propanediol, 2,2-diethyl-1,3-propanediol, 2,2,4-trimethyl-1,3-propanediol, 2-butyl-2-ethyl-1,3-propanediol, 1,2-butanediol, 1,3-butanediol, 2,3-butanediol, 1,4-butanediol (BD), 1,5- pentanediol (PD), neopentyl glycol, 1,6-hexanediol, 2,5-dimethyl-2,5-hexanediol, 3-methyl-1,5-pentanediol (MPD), 1,4-cyclohexanediol , cyclohexanedimethanol (1,4-cyclohexanedimethanol, and the like), 1,9-nonanediol (ND), triethylene glycol. Among these, 1,4-butanediol (BD), 1,5-pentanediol (PD), and 3-methyl-1,5-pentanediol (MPD) are preferable.

{Diamines having a molecular weight of 300 or less}

Examples of diamines having a molecular weight of 300 or less include ethylenediamine, trimethylenediamine, tetramethylenediamine, hexamethylenediamine, heptamethylenediamine, octamethylenediamine, nonamethylenediamine, decamethylenediamine, undecamethylenediamine, dodecamethylenediamine, 2,2,4-trimethylhexamethylenediamine, 2,4,4-trimethylhexamethylenediamine, 3-methylpentamethylenediamine, 1,2-cyclohexanediamine, 1,3-cyclohexanediamine, 1,4-cyclohexanediamine, 1,2-diaminopropane, hydrazine, xylylene diamine, isophoronediamine, piperazine, o-phenylenediamine, m-phenylenediamine, p-phenylenediamine, tolylenediamine, xylenediamine, adipic acid dihydrazide, isophthalic acid dihydrazide, 4,4'-diaminodiphenylmethane, 4,4'-diaminodiphenyl ether, 4,4'-bis(4-aminophenoxy)biphenyl,  4,4'-bis(3-aminophenoxy)biphenyl,  1,4-bis(4-aminophenoxy)benzene,  1,3-bis(4-aminophenoxy) benzene, 1,3-bis(3-aminophenoxy)benzene, 3,4'-diaminodiphenyl ether, 4,4'-diaminodiphenylsulfone, 3,4-diaminodiphenylsulfone, 3,3'- diaminodiphenylsulfone, 4,4'-methylene-bis(2-chloroaniline), 3,3'-dimethyl-4,4'-diaminobiphenyl, 4,4'-diaminodiphenylsulfide, 2,6-diaminotoluene, 2,4-diaminochlorobenzene, 1,2-diaminoanthraquinone, 1,4-diaminoanthraquinone, 3,3'-diaminobenzophenone, 3,4-diaminobenzophenone, 4,4'-diaminobenzophenone, 4,4'-diamino bibenzyl, 2,2'-diamino-1,1'-binaphthalene, l,n-bis(4-aminophenoxy)alkane (n is 3 to 10) such as 1,3-bis(4-aminophenoxy)alkane, 1,4-bis(4-aminophenoxy)alkane, and 1,5-bis(4-aminophenoxy)alkane, 1,2-bis[2-(4-aminophenoxy)ethoxy]ethane, 9,9-bis (4-aminophenyl)fluorene, and 4,4'-diaminobenzanilide.

[Blending ratio of raw materials of polyurethane (PU)]

When polyurethane (PU) contains a structural unit derived from a polymer polyol, a structural unit derived from polyisocyanate, and a structural unit derived from a chain extender, the blending ratio of these raw materials when producing polyurethane (PU) is not particularly limited, however, with respect to the total of 1 mole of the active hydroxyl group in the polymer polyol and the active hydrogen-containing functional group in the chain extender, the amount of isocyanate groups in the polyisocyanate is preferably 0.7 to 1.3 mole, more preferably 0.8 to 1.2 mole, even more preferably 0.9 to 1.1 mole.

When the blending ratio of each component is equal to or greater than the above lower limit value, the mechanical strength and abrasion resistance of polyurethane (PU) improve, and the life of the polishing layer also tends to be longer. Moreover, when the blending ratio of each component is equal to or less than the above upper limit value, the productivity and storage stability of polyurethane (PU) improve, and the polishing layer tends to be easier to manufacture.

Note that "the active hydrogen-containing functional group in the chain extender" means a hydroxyl group when the chain extender is a diol, and means an amino group when the chain extender is a diamine.

When polyurethane (PU) contains a structural unit derived from a polymer polyol and a structural unit derived from a chain extender, the blending ratio of the chain extender when producing polyurethane (PU) is not particularly limited, however, with respect to 1 mole of the active hydroxyl group in the polymer polyol, the active hydrogen-containing functional groups in the chain extender is preferably I to 30 moles, more preferably 4 to 20 moles, even more preferably 8 to 15 moles.

When the blending ratio of the chain extender is within the above range, the polishing layer that maintains required properties such as elongation at break, rigidity, hardness, and hydrophilicity tends to be easily obtained.

[Other structural units]

Polyurethane (PU) may contain other structural units other than structural units derived from polymer polyols, structural units derived from polyisocyanates, and structural units derived from chain extenders, however it may preferably not contain them.

The total content of the structural unit derived from polymer polyol, the structural unit derived from polyisocyanate, and the structural unit derived from a chain extender, with respect to the total structural units contained in polyurethane (PU), is not particularly limited, however, it is preferably 80 % by mass or more, more preferably 85 % by mass or more, even more preferably 90 % by mass or more, even further preferably 95 % by mass or more, most preferably 100 % by mass.

(Additive)

Polyurethane (PU) may or may not contain additives, as necessary.

Examples of the additives include crosslinking agent, filler, crosslinking accelerator, crosslinking aid, softener, tackifier, anti-aging agent, foaming agent, processing aid, adhesion agent, inorganic filler, organic filler, crystal nucleating agent, heat-resistant stabilizers, weathering stabilizers, antistatic agents, colorants, lubricants, flame retardants, flame retardant aids (antimony oxide, and the like), anti-blooming agents, mold release agents, thickeners, antioxidants, conductive agents.

When polyurethane (PU) contains an additive, the additive is also a part of the components constituting polyurethane (PU), and the elongation at break, yield stress, D hardness, contact angle with water and density means the values measured by using polyurethane (PU) containing additives as a constituent component. Note that the abrasive grains are not included in the additives constituting polyurethane (PU).

The total content of the additives in polyurethane (PU) is not particularly limited, however it is preferably 50% by mass or less, more preferably 20% by mass or less, even more preferably 10% by mass or less, even further preferably 1% by mass or less, based on solid content of polyurethane (PU).

(Method for producing polyurethane (PU))

Polyurethane (PU) can be obtained by polymerization using the above-described raw materials by a urethanization reaction using the known prepolymer method or a one-shot method. More specifically, the examples include a method by melt polymerization in which the above-described each component is blended in a predetermined ratio and melt-mixed using a single-screw or multi-screw extruder to produce in substantially absence of a solvent, and a method by polymerization to produce using a prepolymer method in the presence of a solvent. Note that the melt polymerization may be performed continuously.

In the present invention, from the viewpoint of performing a production of polyurethane (PU) stably, it is preferable to use melt polymerization.

(Content of polyurethane (PU))

The content of polyurethane (PU) in the polishing layer of the present invention is not particularly limited, however it is preferably 50% by mass or more, more preferably 70% by mass or more, even more preferably 90% by mass or more, even further preferably 100% by mass.

<Density of Polishing layer>

The density of the polishing layer of the present invention is not particularly limited, however it is preferably 0.7 g/cm$^3$ or more, more preferably 0.8 g/cm$^3$ or more, even more preferably 1.0 g/cm$^3$ or more.

When the density of the polishing layer is within the above range, it tends to be possible to highly achieve both polishing uniformity and low defect properties.

The upper limit value of the density of the polishing layer of the present invention is not particularly limited, however it may be 1.4 g/cm$^3$ or less, 1.3g/cm$^3$ or less, or 1.25g/cm$^3$ or less, from the viewpoint of ease of manufacturing.

The density can be determined as weight (g) relative to external dimension (cm$^3$), and specifically, can be measured according to the method described in Examples.

<Shape of Polishing layer, and the like>

The polishing layer of the present invention is preferably a molded article of polyurethane (PU).

When the polishing layer of the present invention is a molded article of polyurethane (PU), the molded article may be a foamed molded article or a non-foamed molded article, however it is preferably a non-foamed molded article. When the polishing layer of the present invention is a non-foamed molded article, polishing uniformity is high, and it is possible to further suppress variations in foam distribution, the occurrence of defects caused by aggregates in the foam, and the like.

The thickness of the polishing layer of the present invention is not particularly limited, however it is preferably 0.5 to 5.0 mm, more preferably 1.0 to 3.0 mm, even more preferably 1.2 to 2.5 mm.

When the thickness of the polishing layer is within the above-described range, the productivity and handling properties are improved, and the stability of the polishing properties tends to be improved.

The polishing layer of the present invention preferably contains recesses on the polishing surface. The recess may or may not penetrate the polishing layer.

The shape of the recess is not particularly limited, however it is preferably a shape such as groove and hole. Note that the term "groove" here refers to a recess formed linearly in a plan view of the polishing layer, and the term "hole" refers to a recess formed in a nonlinear shape, for example a circular shape, in the plan view of the polishing layer.

It is preferable that in the plan view of the polishing layer, grooves are formed in a predetermined pattern such as concentric, lattice, spiral, and radial patterns. The grooves preferably do not penetrate the polishing layer.

It is preferable that in the plan view of the polishing layer, holes are formed in a predetermined pattern such as circular shape, oval shape, and polygonal shape. The hole preferably has a recessed shape which does not penetrate the polishing layer.

Such recesses supply slurry uniformly and sufficiently to the polishing surface, and are useful for discharging polishing debris that causes the occurrence of defects, preventing damage of a wafer due to adsorption of the polishing layer, and the like.

When the polishing layer of the present invention for example, has grooves of concentric or spiral patterns on the polishing surface, the interval between grooves is not particularly limited, however it is preferably 1.0 to 50 mm, more preferably 1.5 to 30 mm, even more preferably 2.0 to 15 mm. Further, the width of the groove is not particularly limited, however it is preferably 0.1 to 3.0 mm, more preferably 0.2 to 2.0 mm. Furthermore, the depth of the groove is not particularly limited, however it is less than the thickness of the polishing layer, and it is preferably 0.2 to 1.8 mm, more preferably 0.4 to 1.5 mm.

As a cross-sectional shape of the groove, it is appropriately selected, for example, from a rectangle, a trapezoid, a triangle, and a semicircle, depending on the purpose.

When the polishing layer of the present invention has holes on the polishing surface, the depth of the hole is not particularly limited, however it is equal to or less than the thickness of the polishing layer, and it is preferably 0.2 to 5.0 mm, more preferably 0.4 to 3.0 mm, even more preferably 0.4 to 2.5 mm.

<Method for producing Polishing layer>

The polishing layer of the present invention can be produced, for example, by a method in which a molded article containing polyurethane (PU) is obtained and, if necessary, the molded article is processed.

A molded article containing polyurethane (PU) can be obtained by, for example, after pelletizing the polyurethane (PU) obtained by the above method, and molding by various molding methods such as extrusion molding, injection molding, blow molding, and calendar molding. Particularly, it is easy to obtain a sheet-shaped molded article which has a uniform thickness by extrusion molding using a T-die.

Thereafter, the shape, thickness, and the like, of the molded article can be adjusted as necessary by subjecting the molded article containing polyurethane (PU) to processing such as machining, slicing, and punching.

When forming recesses in the polishing layer, for example, they may be formed by subjecting a molded article containing polyurethane (PU) to grinding processing, laser processing, stamping with a heated mold, and the like, or they may also be formed by transferring with a mold during injection molding polyurethane.

[Polishing pad]

The polishing pad of the present invention is a polishing pad equipped with the polishing layer of the present invention.

The polishing pad of the present invention may only contain the polishing layer of the present invention, or may be a laminate in which a cushion layer is laminated on the surface which is not the polishing surface of the polishing layer of the present invention.

The cushion layer is preferably a layer having a lower hardness than the hardness of the polishing layer. When the hardness of the cushion layer is lower than the hardness of the polishing layer, the rigid polishing layer follows local unevenness on the surface to be polished, and the cushion layer follows the warping and swelling of the entire substrate to be polished, therefore, the polishing with an excellent balance between global planarity (a state in which unevenness of wafer substrate having large cycles is reduced) and local planarity (a state in which local unevenness is reduced) can be achieved.

Examples of materials used as the cushion layer include composites of nonwoven fabric impregnated with polyurethane (for example, "Suba400" (manufactured by Nitta Haas Co., Ltd.)); rubbers such as natural rubber, nitrile rubber, polybutadiene rubber, and silicone rubber; thermoplastic elastomers such as polyester-based thermoplastic elastomers, polyamide-based thermoplastic elastomers, and fluorine-based thermoplastic elastomers: foamed plastics; and polyurethane.

Among these, the polyurethane having a foamed structure is preferred since the suitable flexibility for the cushion layer is easily obtained.

The thickness of the cushion layer is not particularly limited, however, it is preferably about 0.5 to 5 mm. When the thickness of the cushion layer is equal to or greater than the above lower limit value, the effect of following the entire warp, swelling, and the like, of the surface to be polished will be sufficient, and the global flatness will tend to be better. Moreover, when the thickness of the cushion layer is less than the above upper limit value, the entire polishing pad has appropriate hardness, and polishing stability tends to be better.

The preferred thickness of the polishing pad of the present invention is the same as the preferred thickness of the polishing layer of the present invention described above when the polishing pad of the present invention does not have a cushion layer. Further, when the polishing pad of the present invention has a cushion layer, the thickness of the polishing pad of the present invention is preferably 1 to 10mm.

[Method for producing Polishing pad]

A method for producing a polishing pad of the present invention is a method for producing a polishing pad which contains one or more steps selected from the group consisting of a step of forming the polishing layer of the present invention and a step of processing the polishing layer of the present invention.

Examples of the step of forming the polishing layer of the present invention include the method described in the above <Method for producing Polishing layer> . When the polishing pad of the present invention only contains the polishing layer of the present invention, the polishing pad of the present invention can be produced by a step of forming the polishing layer of the present invention.

Examples of the step of processing the polishing layer of the present invention include a step of laminating a cushion layer on the surface which is not the polishing surface of the polishing layer of the present invention. The cushion layer can be laminated, for example, by using a double-sided adhesive sheet and attaching it to the surface which is not the polishing surface of the polishing layer of the present invention.

[Polishing method]

The polishing method of the present invention is a polishing method which uses the polishing pad of the present invention.

An embodiment in which a polishing method using the polishing pad of the present invention is performed by CMP will be described with reference to Fig.1.

In CMP, a CMP apparatus 10 equipped with a circular rotating surface plate 2. a slurry supply nozzle 3. a holder 4, and a pad conditioner 6 shown in Fig. 1 is used. A polishing pad 1 equipped with the polishing layer described above is attached to the surface of the rotating surface plate 2 using double-sided tape and the like. Further, the holder 4 supports an object to be polished 5.

In the CMP apparatus 10, the rotating surface plate 2 is rotated in the direction shown by the arrow (clockwise) by a motor which is not shown. Further, the holder 4 is rotated, for example, in the direction shown by the arrow (clockwise) by a motor which is not shown, in the plane of the rotating surface plate 2. Further, the pad conditioner 6 is also rotated, for example, in the direction shown by the arrow (clockwise) by a motor which is not shown, in the plane of the rotating surface plate 2.

First, while distilled water is flowing on the polishing surface of the polishing pad 1 which rotates by fixed to the rotating surface plate 2, for example, the conditioning of the polishing surface of the polishing pad 1 is performed by pressing the pad conditioner 6 for CMP, in which diamond particles are fixed to the surface of the carrier by nickel electrodeposition and the like. The polishing surface is adjusted to a suitable surface roughness for polishing the surface to be polished, by the conditioning. Next, slurry 7 is supplied from the slurry supply nozzle 3 to the polishing surface of the polishing pad 1 which rotates. Further, when performing CMP, a lubricating oil, a coolant, and the like may be used together with the slurry, if necessary.

Examples of the slurry include acidic slurry, alkaline slurry, and near-neutral slurry. Here, as the slurry, for example, liquid media such as water and oil: abrasive grains such as silica, alumina, cerium oxide, zirconium oxide, and silicon carbide; slurry used in CMP containing a base, an acid, a surfactant, oxidizing agents such as aqueous hydrogen peroxide, a reducing agent, a chelating reagent, and the like, are preferably used.

Then, the object to be polished 5 which rotates by fixed to the holder 4 is pressed to the polishing pad 1 in which the slurry 7 evenly distributed over the polishing surface of the polishing layer. The polishing process is then continued until a predetermined planarity is obtained. The finish quality is affected by adjusting the pressing force which is applied during polishing and the speed of relative movement between the rotating surface plate 2 and the holder 4.

The polishing conditions are not particularly limited, however in order to perform polishing efficiently, it is preferable that the rotation speed of the rotating surface plate and the holder is preferably low, 300 rpm or less, and the pressure applied to the object to be polished is preferably set to be 150 kPa or less, to prevent the occurrence of scratches after polishing. During polishing, it is preferable to continuously supply the slurry to the polishing surface using a pump and the like. Although the amount of slurry supplied is not particularly limited, it is preferable to supply the slurry so that the polishing surface is always covered with the slurry.

It is preferable that the object to be polished after completing the polishing is thoroughly washed with flowing water, and then water droplets adhering to the object to be polished are removed using a spin dryer and the like, to be dried. By polishing the surface to be polished with slurry in this manner, a smooth surface can be obtained over the entire surface of the surface to be polished. Note that the above-described CMP can be suitably used for polishing various semiconductor materials such as silicon wafers.

Example

An example of the present invention will be explained below using Examples. Note that the scope of the present invention is not limited by the following examples.

[Example 1]

Polytetramethylene glycol (PTMG850) having a number average molecular weight of 850 and polyethylene glycol (PEG600) having a number average molecular weight of 600 as a polymer polyol, cis-2-butene-1,4-diol (CBD) and 1,5-pentane diol (PD) as a chain extender, and 4,4'-diphenylmethane diisocyanate (MDI) as a polyisocyanate are blended in a ratio described in Table 1, to prepare a prepolymer.

Further, the obtained prepolymer was kneaded in a small kneader at a condition of 240 °C and a screw rotation speed of 100 rpm for 5 minutes, and then shredded by a pelletizer to obtain pellets of polyurethane. The obtained pellets were supplied to a single screw extruder and extruded from a T-die to form into sheet shape. Then, the surface of the obtained sheet was ground to obtain a uniform sheet with a thickness of 2.0 mm, and the sheet was cut out into a circular shape with a diameter of 740 mm to obtain a polyurethane sheet which is a non-foamed molded article of thermoplastic polyurethane as a polishing layer.

[Examples 2 to 12, Comparative examples 1 to 6]

A polyurethane sheet which is a non-foamed molded article of thermoplastic polyurethane, was obtained as a polishing layer in the same manner as in Example 1, except that the raw material composition of polyurethane was changed to the raw material composition listed in Table 1, in Example 1.

[Comparative example 7]

The polyurethane sheet obtained in Comparative Example 6 was immersed in a 0.25% by mass aqueous solution of sorbic acid (SBA) at 50°C, taken out after left for 24 hours, washed with water, and dried. A polyurethane sheet which was subjected to a modification process in this way was obtained as a polishing layer.
Note that the raw materials described in Table 1 are as follows.

(Polymer polyol)

·PTMG850: polytetramethylene glycol having a number average molecular weight 850
·PEG600: polyethylene glycol having a number average molecular weight 600

(Chain extender)

·CBD: cis-2-butene-1,4-diol
·TBD: trans-2-butene-1,4-diol
·BDM: 1.4-benzenedimethanol
·BD: 1,4-butanediol
·PD: 1,5-pentanediol
·MPD: 3-methyl-1,5-pentanediol

(Polyisocyanate)

·MDI: 4,4'-diphenylmethane diisocyanate

[Evaluation method]

Each evaluation was performed on the polyurethane sheet as a polishing layer obtained in each example according to the following method.

<Elongation at break and Yield stress>

The polyurethane sheet obtained in each Example as a polishing layer was sandwiched between two metal plates and was subjected to a heat press molding using a heat press molding machine (desktop test press manufactured by Shinto Metal Industries Ltd.). In heat press molding, after preheating at a heating temperature of 230 °C for 2 minutes, pressing was performed for 1 minute at a pressing pressure such that the thickness was 500 $\mu$m. Then, after the two metal plates in which the polyurethane sheet was interposed from the heat press molding machine, were taken out and cooled, the polyurethane sheet which was press-molded to a thickness of 500 $\mu$m was released from both sides of the metal plates.
A water swelling measurement sample was prepared by immersing the press-molded polyurethane sheet obtained above in water at 50° C for 48 hours to be saturated and swollen by water. The water swelling measurement sample was subjected to a tensile test in accordance with JIS K 7311:1995, using Autograph SHIMADZU AGS-H manufactured by Shimadzu Corporation, except that the tensile speed was 50 mm/min, and the elongation at break and the yield stress were measured. Note that the elongation at break is calculated by the following formula.

$$\text{Elongation at break (\%)} = \{(L\text{-}L_0)/L_0\} \times 100$$

L= Distance between marked lines at break
Lu=Distance between marked lines before test
The results are shown in Table 1 as elongation at break (wet) and yield stress (wet).

<D hardness>

Using a water swelling sample obtained by immersing the polyurethane sheet as a polishing layer obtained in each example in 50°C water for 48 hours to be saturated and swollen by water, the D hardness (JIS- D hardness) was measured, according to JIS K 7311:1995. The results are shown in Table 1 as D hardness (wet).

<Contact angle with water>

The polyurethane sheet obtained in each example as a polishing layer was placed so that at least one side was in contact with a polyimide film in order to make the measurement surface smooth, and was further sandwiched between two metal plates and was heat press molded using a heat press molding machine (desktop test press manufactured by Shinto Metal Industries Ltd.). In heat press molding, after preheating at a heating temperature of 230 °C for 2 minutes, pressing was performed for 1 minute at a pressing pressure such that the thickness was 200 $\mu$m. Then, after the two metal plates in which the polyurethane sheet was interposed from the heat press molding machine, were taken out and cooled, the polyurethane sheet which was press-molded to a thickness of 200 $\mu$m was released from both sides of the metal plates.
The press molded polyurethane sheet obtained by the above was placed under the condition of the room temperature (23 °C) and 50% RH for 3 days, the contact angle with water was measured using DropMaster 500 manufactured by Kyowa Interface Science Co., Ltd., 2 seconds after dropping 2.5 $\mu$L of room temperature (23°C) water onto the surface which was in contact with the polyimide film, in an environment where there is no direct wind. The results are shown in Table 1 as contact angle (immediately after).

<PEG ratio in polymer polyol>

The PEG ratio in the polymer polyol was calculated using the number average molecular weight of each polymer polyol and the numerical value of mass% of the polymer polyol in Table 1. For example, in Example 1, it was calculated by the following formula "(7.5$\div$600)$\div$((7.1=850)+7.5$\div$600))$\times$100=60". The results are shown in Table 1.

<Density of Polishing layer>

The polyurethane sheet as a polishing layer obtained in each example was cut into a rectangle (50 mm long $\times$ 50 mm wide) in plan view, and this was used as a sample piece. The apparent volume ($cm^3$) of the sample piece is calculated from the external dimensions of the sample piece (i.e., 50 mm long $\times$ 50 mm wide $\times$ 2.0 mm thick), the weight (g) of the sample piece was measured, and the density was calculated using the following formula. The results are shown in Table 1.

$$\text{Density (g/cm}^3) = \text{Weight (g) of sample piece / Apparent volume (cm}^3) \text{ of sample piece}$$

<Preparation of Polishing pad>

(Groove processing)

A groove having a spiral pattern was formed by machining processing on one surface of the polishing surface of the polyurethane sheet as a polishing layer obtained in each example.

(Laminating of Cushion layer)

Next, a cushion layer was bonded on the side of the polyurethane sheet opposite to the side where the grooves were formed, with double-sided adhesive sheet, to form a multilayer polishing pad. As the cushion layer, "PORON H-48" manufactured by INOAC Corporation (foamed polyurethane sheet with a thickness of 0.8 mm), was used.

<Polishing test>

The obtained polishing pad was attached to a polishing device "F·REX300" manufactured by Ebara Corporation. Then, slurry was prepared by diluting the slurry "SEMI-SPERSE25" manufactured by Cabot Microelectronics, twice to be controlled, and a silicon wafer with a diameter of 12 inches and having a silicon oxide film with a film thickness of 2000 nm on its surface was polished for 60 seconds, while supplying the slurry to the polishing surface of the polishing pad at a rate of 200 mL/min under the conditions of platen rotation speed 100 rpm, head rotation speed 99 rpm, and polishing pressure of 20.0 kPa.

Then, the surface of the polishing pad was conditioned for 30 seconds, using a pad conditioner (Diamond Dresser manufactured by Asahi Diamond Industrial Co., Ltd. (Diamond 100 grit, block, base metal diameter 11.6 cm)), while flowing pure water at a rate of 150 mL/min under the conditions of dresser rotation speed of 70 rpm, polishing pad rotation speed of 100 rpm, and dresser load of 35 N. Then, another silicon wafer was polished for 60 seconds, and further conditioned for 30 seconds. Ten silicon wafers were polished in this way.

<Measurement of defect number>

The surface to be polished of the silicon wafer which was polished tenth, was inspected using a defect inspection device manufactured by KLA Corporation, and the defect number having a size of 160 nm or more was measured.

<Measurement of coefficient of variation of polishing rate>

Film thickness of silicon oxide film before and after polishing the silicon wafer which was polished tenth, was measured at 49 points within the wafer surface (edge exclusion 3 mm), the polishing rate (nm/min) at each point was determined, the average value and standard deviation $1\sigma$ of the polishing rate at the 49 points were calculated, and a coefficient of variation (unit: %) was determined from the average value and standard deviation $1\sigma$, and this was used as an indicator of polishing uniformity. The smaller the coefficient of variation, the better polishing uniformity.

Table 1

| | | Example | | | | | |
|---|---|---|---|---|---|---|---|
| | | 1 | 2 | 3 | 4 | 5 | 6 |
| Raw material composition of polyurethane (mass%) | PTMG850 | 7.1 | 12.2 | 13.0 | 16.2 | 13.6 | 19.3 |
| | PEG600 | 7.5 | 3.7 | 2.3 | 2.0 | 1.7 | 4.5 |
| | CBD | 6.1 | 6.0 | 8.1 | 9.9 | 10.0 | 5.3 |
| | TBD | | | | | | |
| | BDM | | | | | | |
| | BD | | | | 10.1 | | 12.7 |
| | PD | 16.7 | 16.5 | 14.3 | | | |
| | MPD | | | | | 13.4 | |
| | MDI | 62.6 | 61.7 | 62.3 | 61.8 | 61.3 | 58.1 |
| Physical properties of polyurethane, and the like | Properties | Thermoplastic | Thermoplastic | Thermoplastic | Thermoplastic | Thermoplastic | Thermoplastic |
| | Shape | Non-foamed | Non-foamed | Non-foamed | Non-foamed | Non-foamed | Non-foamed |
| | Elongation at break (wet) [%] | 85 | 55 | 93 | 95 | 90 | 95 |
| | Yield stress (wet) [MPa] | 46 | 62 | 65 | 53 | 56 | 40 |
| | D hardness (wet) | 81 | 82 | 81 | 82 | 80 | 70 |
| | Contact angle with water (immediately after) [°] | 69 | 68 | 65 | 65 | 62 | 64 |
| | PEG ratio in polymer polyol [mol%] | 60 | 30 | 20 | 15 | 15 | 25 |
| Density of polishing layer [g/cm³] | | 1.2 | 1.2 | 1.2 | 1.1 | 1.0 | 1.1 |
| Evaluation result | (Polishing uniformity) Coefficient of variation of polishing rate [%] | 1.9 | 2.3 | 2.5 | 2.7 | 3.1 | 4.5 |
| | (Low defect property) Defect number [spot] | 55 | 61 | 69 | 75 | 81 | 84 |

Table 1 (continued)

| | | Example | | | | | |
|---|---|---|---|---|---|---|---|
| | | 7 | 8 | 9 | 10 | 11 | 12 |
| Raw material composition of polyurethane (mass%) | PTMG850 | 20.0 | 13.4 | 20.7 | 14.3 | 10.2 | 10.7 |
| | PEG600 | 3.5 | 1.7 | 1.6 | | 7.2 | 7.6 |
| | CBD | 8.6 | 5.9 | 5.5 | 6.2 | | |
| | TBD | | | | | 5.8 | |
| | BDM | | | | | | 8.6 |
| | BD | | | 13.2 | | | |
| | PD | | | | 17.0 | 16.0 | 15.1 |
| | MPD | 11.6 | 18.5 | | | | |
| | MDI | 56.3 | 60.5 | 59.0 | 62.6 | 60.8 | 58.1 |
| Physical properties of polyurethane, and the like | Properties | Thermoplastic | Thermoplastic | Thermoplastic | Thermoplastic | Thermoplastic | Thermoplastic |
| | Shape | Non-foamed | Non-foamed | Non-foamed | Non-foamed | Non-foamed | Non-foamed |
| | Elongation at break (wet) [%] | 97 | 80 | 90 | 85 | 91 | 90 |
| | Yield stress (wet) [MPa] | 51 | 55 | 57 | 48 | 50 | 53 |
| | D hardness (wet) | 60 | 79 | 75 | 78 | 78 | 76 |
| | Contact angle with water (immediately after) [°] | 61 | 75 | 67 | 70 | 68 | 70 |
| | PEG ratio in polymer polyol [mol%] | 20 | 15 | 10 | 0 | 50 | 50 |
| Density of polishing layer [g/cm$^3$] | | 0.9 | 1.1 | 1.0 | 1.2 | 1.2 | 1.2 |
| Evaluation result | (Polishing uniformity) Coefficient of variation of polishing rate [%] | 4.1 | 3.8 | 3.5 | 4.0 | 3.9 | 4.2 |
| | (Low defect property) Defect number [spot] | 85 | 94 | 87 | 91 | 73 | 92 |

Table 1 (continued)

| | | | Comparative example | | | | | | |
|---|---|---|---|---|---|---|---|---|---|
| | | | 1 | 2 | 3 | 4 | 5 | 6 | 7 |
| Raw material composition of polyurethane (mass%) | | PTMG850 | 28.2 | 26.1 | 33.6 | 19.0 | 14.5 | 20.9 | 20.9 |
| | | PEG600 | 5.0 | 3.3 | | | | | |
| | | CBD | | | | | | 3.7 | 3.7 |
| | | TBD | | | | | | | |
| | | BDM | | | | | | | |
| | | BD | 14.9 | 16.3 | 15.0 | 14.7 | 14.7 | | |
| | | PD | | | | | | 17.3 | 17.3 |
| | | MPD | | | | 6.4 | 8.3 | | |
| | | MDI | 51.9 | 54.3 | 51.4 | 59.9 | 62.6 | 58.1 | 58.1 |
| Physical properties of polyurethane, and the like | | Properties | Thermoplastic | Thermoplastic | Thermoplastic | Thermoplastic | Thermoplastic | Thermoplastic | Thermoplastic |
| | | Shape | Non-foamed | Non-foamed | Non-foamed | Non-foamed | Non-foamed | Non-foamed | Non-foamed |
| | | Elongation at break (wet) [%] | 475 | 320 | 450 | 265 | 250 | 105 | 275 |
| | | Yield stress (wet) [MPa] | 42 | 43 | 42 | 45 | 44 | 44 | 42 |
| | | D hardness (wet) | 60 | 62 | 60 | 64 | 75 | 73 | 68 |
| | | Contact angle with water (immediately after) [°] | 69 | 70 | 70 | 70 | 76 | 72 | 69 |
| | | PEG ratio in polymer polyol [mol%] | 10 | 15 | 0 | 0 | 0 | 0 | 0 |
| | Density of polishing layer [g/cm³] | | 1.0 | 1.1 | 1.0 | 1.2 | 1.0 | 1.2 | 1.2 |
| Evaluation result | | (Polishing uniformity) Coefficient of variation of polishing rate [%] | 5.7 | 6.2 | 6.3 | 5.3 | 6.0 | 5.3 | 6.4 |
| | | (Low defect property) Defect number [spot] | 134 | 179 | 171 | 236 | 295 | 114 | 242 |

As is clear from the results in Table 1, it is found that the polishing pads produced in Examples 1 to 12 and equipped with the polishing layer of the present invention containing polyurethane (PU) having an elongation at break after water swelling of less than 100% can highly achieve both polishing uniformity and low defect properties. On the other hand, in the polishing pads produced in Comparative Examples 1 to 7 and equipped with a polishing layer using polyurethane having an elongation at break after water swelling of 100% or more, polishing uniformity and low defect properties were inferior to Examples 1 to 12.

Reference Signs List

1 Polishing pad
2 Rotating surface plate
3 Slurry supply nozzle
4 Holder
5 Object to be polished
6 Pad conditioner
7 Slurry
10 CMP apparatus

**Claims**

1. A polishing layer comprising a polyurethane,
   wherein an elongation at break of the polyurethane at the tensile speed of 50 mm/min after saturated and swollen by water of 50 °C is less than 100 %.

2. The polishing layer according to claim 1,
   wherein a yield stress of the polyurethane at the tensile speed of 50 mm/min after saturated and swollen by water of 50 °C is 43 MPa or more.

3. The polishing layer according to claim 1 or 2,
   wherein a D hardness of the polyurethane after saturated and swollen by water of 50 °C is 65 or more.

4. The polishing layer according to any one of claims 1 to 3,
   wherein a contact angle with water of the polyurethane is less than 75 degrees.

5. The polishing layer according to any one of claims 1 to 4,

   wherein the polyurethane contains structural units derived from polymer polyol,
   wherein the polymer polyol contains 15 mol% or more of polyethylene glycol.

6. The polishing layer according to any one of claims 1 to 5,
   wherein the polyurethane is thermoplastic.

7. The polishing layer according to any one of claims 1 to 6, having a density of 0.7 g/cm$^3$ or more.

8. The polishing layer according to any one of claims 1 to 7, which is a molded article of the polyurethane.

9. The polishing layer according to claim 8,
   wherein the molded article is a non-foamed molded article.

10. The polishing layer according to any one of claims 1 to 9,
    wherein the polishing layer contains recesses on a polishing surface.

11. A polishing pad equipped with the polishing layer according to any one of claims 1 to 10.

12. A method for producing a polishing pad, which is a method for producing the polishing pad according to claim 11, comprising one or more steps selected from the group consisting of a step of forming the polishing layer and a step of processing the polishing layer.

13. A polishing method which uses the polishing pad according to claim 11.

[Fig. 1]

## INTERNATIONAL SEARCH REPORT

| | International application No. |
|---|---|
| | **PCT/JP2023/003092** |

### A. CLASSIFICATION OF SUBJECT MATTER

***B24B 37/24***(2012.01)i; ***C08G 18/00***(2006.01)i; ***H01L 21/304***(2006.01)i
FI: B24B37/24 C; H01L21/304 622F; C08G18/00

According to International Patent Classification (IPC) or to both national classification and IPC

### B. FIELDS SEARCHED

Minimum documentation searched (classification system followed by classification symbols)

B24B37/24; C08G18/00; H01L21/304

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2017-185566 A (FUJIBO HOLDINGS, INC.) 12 October 2017 (2017-10-12) paragraphs [0022]-[0070] | 1-13 |
| A | WO 2019/216279 A1 (KURARAY CO., LTD.) 14 November 2019 (2019-11-14) | 1-13 |
| A | JP 2008-207325 A (KURARAY CO., LTD.) 11 September 2008 (2008-09-11) | 1-13 |

☐ Further documents are listed in the continuation of Box C. ☑ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | |
| "O" | document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" | document published prior to the international filing date but later than the priority date claimed | "&" document member of the same patent family |

| Date of the actual completion of the international search | Date of mailing of the international search report |
|---|---|
| **07 April 2023** | **18 April 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2023/003092**

| Patent document cited in search report | | | Publication date (day/month/year) | Patent family member(s) | | | Publication date (day/month/year) |
|---|---|---|---|---|---|---|---|
| JP | 2017-185566 | A | 12 October 2017 | (Family: none) | | | |
| WO | 2019/216279 | A1 | 14 November 2019 | US | 2021/0276143 | A1 | |
| | | | | EP | 3792295 | A1 | |
| | | | | KR | 10-2020-0136982 | A | |
| | | | | CN | 112105667 | A | |
| JP | 2008-207325 | A | 11 September 2008 | US | 2010/0087128 | A1 | |
| | | | | WO | 2008/093850 | A1 | |
| | | | | EP | 2123400 | A1 | |
| | | | | KR | 10-2009-0101949 | A | |
| | | | | CN | 101600540 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9907515 A
- JP 2016068250 A